Europäisches Patentamt

European Patent Office

Office européen des brevets

(11) Numéro de publication: **0 001 665**
A1

## (12) DEMANDE DE BREVET EUROPEEN

(21) Numéro de dépôt: 78200245.5

(22) Date de dépôt: 17.10.78

(51) Int. Cl.²: **H 01 L 31/04**

(30) Priorité: 20.10.77 CH 12784/77

(43) Date de publication de la demande:
02.05.79 Bulletin 79/9

(84) Etats contractants désignés:
BE DE FR GB LU NL SE

(71) Demandeur: Baude, Pierre
Résidence du Midi 29, rue de la Prulay
CH-1217 - Meyrin(CH)

(72) Inventeur: Baude, Pierre
Résidence du Midi 29, rue de la Prulay
CH-1217 - Meyrin(CH)

(74) Mandataire: Meylan, Robert Maurice
c/o BUGNION S.A. 10, route de Florissant Case 42
CH-1211 Geneve 2(CH)

(54) **Dispositif générateur d'électricité à partir de la lumière.**

(57) Le dispositif comprend essentiellement un cristal de Si (19) dont la surface non exposée à la lumière est en contact avec une première résine semi-conductrice (18) constituée par un mélange de sulfure de cuivre et de résine synthétique. Ce cristal de Si est en contact avec une deuxième résine semi-conductrice (23), également constituée par un mélange de sulfure de cuivre et de résine synthétique, et avec une matière (22) absorbant les électrons, par exemple de l'indium, noyée dans la première résine, mais séparée de celle-ci par la deuxième résine semi-conductrice (23). Cette deuxième résine contient environ 5 à 20% de plus de résine synthétique que la première résine. Cette dernière est supportée par un corps conducteur (17) et des moyens de connexion (24,25) sont reliés respectivement au corps conducteur et à la matière absorbante. Il est possible de superposer plusieurs cristaux de silicium noyés dans la première resine, par exemple du silicone. Le cristal de silicium exposé à la lumière est protégé par un matériau isolant transparent (21).

FIG. 3

Croydon Printing Company Ltd.

EP 0 001 665 A1

0001665

- 1 -

<u>Dispositif générateur d'électricité à partir de
la lumière</u>.

La présente invention a pour objet un dispositif générateur d'électricité à partir de la lumière comprenant
essentiellement un cristal de silicium exposé à la
lumière.

L'utilisation de l'effet photovoltaïque du silicium
est bien connue. Elle consiste à utiliser une jonction P-N dans un cristal de silicium pour générer des
porteurs de charge par bombardement de photons. Selon
le brevet FR 1.389.820 on a par exemple proposé d'utiliser un mélange de silicium, d'un isolant, par exemple une résine de silicone, et d'un métal avec un autre semi-conducteur mis en contact avec ce mélange
et une électrode disposée sur ce mélange du côté opposé à l'autre semi-conducteur. L'effet photovoltaïque est produit par la combinaison du métal et du silicium contenu dans le mélange.

Le rendement théorique de tels éléments photovoltaïques au silicium n'atteint toutefois que 22%, le rendement réel étant inférieur à 20%. En outre, l'élément photovoltaïque doit recevoir un rayonnement ultra-violet, ce qui signifie qu'il doit être pratiquement exposé à la lumière directe du soleil. Pour avoir une rentabilité raisonnable il est nécessaire d'utiliser un très grand nombre d'éléments photovoltaïques, ce qui nécessite une très grande surface exposée et un prix de revient élevé.

La présente invention a pour but d'utiliser d'une manière beaucoup plus rentable les propriétés semi-conductrices du cristal de silicium. En utilisant une jonction d'un type différent et un effet sensiblement différent de l'effet photovoltaïque on obtient une cellule solaire capable de fournir une puissance beaucoup plus élevée qu'une cellule photovoltaïque, même lorsqu'elle est exposée à la lumière indirecte exempte de rayonnement ultra-violet. Le rendement maximal est d'environ 60% et les premiers résultats obtenus ont permis, sur une surface d'environ $2mm^2$ d'obtenir une tension de 2 volts avec un courant de 20mA, ces résultats étant susceptibles d'amélioration.

Le dispositif générateur d'électricité selon l'invention est caractétisé par le fait que la surface non exposée à la lumière du cristal de silicium est en contact avec une première résine semi-conductrice constituée par un mélange de sulfure de cuivre et de résine synthétique et que ce cristal de silicium, ou un autre cristal de silicium, est en contact avec une deuxième résine semi-conductrice également constituée par un mélange de sulfure de cuivre et de résine

0001665

synthétique et avec une matière absorbant les électrons noyée dans la première résine semi-conductrice mais séparée de cette première résine par la deuxième résine semi-conductrice, la deuxième résine semi-conductrice contenant environ 5 à 20% de plus de résine synthétique que la première résine semi-conductrice, et par le fait qu'il comprend en outre un corps conducteur supportant la première résine semi-conductrice et des moyens de connexions reliés respectivement au corps conducteur et à la matière absorbante.

Le dessin annexé représente, à titre d'exemple, des formes d'exécution de l'invention.

La figure 1 illustre, au moyen des niveaux d'énergie, la différence de principe entre l'effet photovoltaïque et l'effet selon l'invention.

La figure 2 représente schématiquement la jonction P-N utilisée.

La figure 3 représente une première forme d'exécution du dispositif.

La figure 4 représente une seconde forme d'exécution.

La figure 5 représente le schéma de connexion de plusieurs éléments.

La figure 6 est un diagramme illustrant le rendement théorique et pratique d'un élément.

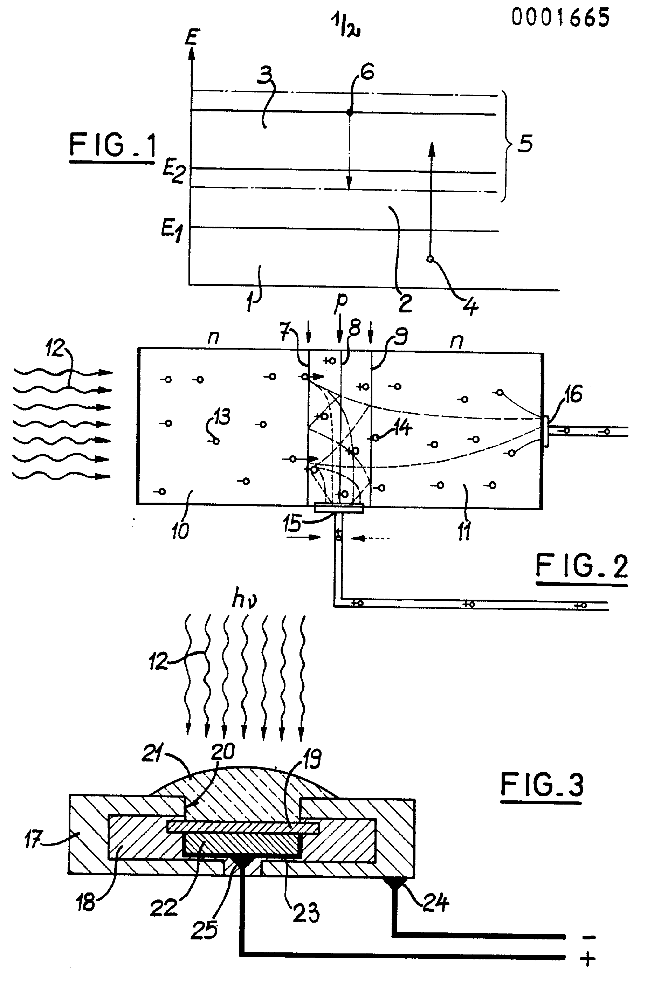

A la figure 1 on a représenté schématiquement en traits pleins les niveaux correspondants à la bande de valence 1, à la bande interdite 2 et à la bande de conduction 3 pour un cristal de silicium. L'énergie minimale de libération d'un électron se trouvant dans la
bande de valence est égale à $E_2-E_1$. En apportant au
silicium une énergie au moins égale à $E_2-E_1$ on peut
faire passer des électrons 4 se trouvant dans la bande
de valence 1 dans la bande de conduction 3, en donnant
naissance à des charges constituées par des paires
d'électrons et de trous. Dans les cellules solaires
cette énergie est constituée par des photons. Cet
effet est l'effet photovoltaïque. Dans le dispositif
selon l'invention une jonction spéciale constitue une
nouvelle bande 5 représentée par les traits mixtes qui
sera appelée bande de "multiplication" car le nombre
de charges obtenues est multiplié par rapport au nombre de charges obtenues par l'effet photovoltaïque. On
sait qu'en théorie un quantum sur la surface du cristal de silicium en extrait un électron. Lorsque le
photon a une énergie supérieure à l'énergie d'extraction E0 l'excédent est emmagasiné par l'électron éjecté sous forme d'énergie cinétique. C'est précisément
cette énergie cinétique qui est utilisée dans le dispositif selon l'invention. Les charges libérées par
les photons incidents donnent naissance à un courant
électrique en traversant une jonction entre une région
résineuse semi-conductrice p et une région résineuse
semi-conductrice n. Les électrons 6 passent d'un niveau supérieur à un niveau inférieur dans la bande
de conduction en libérant une certaine énergie récupérable sous forme d'énergie électrique. Cet effet
distingue fondamentalement l'effet utilisé de l'effet
photovoltaïque.

La figure 2 illustre schématiquement le nouveau type de jonction utilisé. Contrairement à l'unique jonction P-N étroite utilisée dans les cellules photovoltaïques, le dispositif selon l'invention utilise trois jonctions 7,8 et 9. De part et d'autres des jonctions 7 et 9 on a deux zones de silicium dopées de caractère n. La zone comprise entre les jonctions 7 et 9 est constituée par une résine semi-conductrice de caractère p. L'énergie lumineuse $h\nu$ est représentée par les flèches ondulées 12. Sous l'effet de cette énergie, des électrons 13 et 14 des zones 10 et 11 traversent les jonctions 7 et 8. La résine synthétique semi-conductrice permet de récupérer des électrons qui seraient perdus, ce qui est le cas dans les cellules photovoltaïques. La résine semi-conductrice a donc un effet catalyseur et c'est cet effet de catalyse qui permet finalement de capter un grand nombre d'électrons au moyen de deux électrodes 15 et 16.

Le dispositif selon l'invention est représenté dans sa réalisation la plus simple à la figure 3. Le dispositif comporte un corps ou base 17 en métal très conducteur, de préférence en un alliage chrome-nickel-aluminium dans une proportion de 50% chrome/nickel et 50% d'aluminium qui présente l'avantage d'être très léger et de se décharger moins facilement que d'autres conducteurs. Le corps 17 présente une cavité contenant une première résine semi-conductrice 18 constituée par du sulfure de cuivre dilué avec environ 10% de silicone. Dans la résine 18 est partiellement noyé un cristal de silicium 19 de caractère p dont la face supérieure est libre et exposée à la lumière 12 à travers une ouverture 20 du corps 17. Le cristal 19 est toutefois protégé mécaniquement par une substance protectrice transparente 21, par exemple du polyester. La face inférieure du cristal de silicium 19 est en contact avec une matière absorbante conductrice 22, par exemple de l'indium. La surface de la matière absorbante 22 qui n'est pas en contact avec le cristal 19 est enrobée par une deuxième résine semi-conductrice 23 qui sépare totalement la matière absorbante 22 de la première résine semi-conductrice 18. Cette seconde résine semi-conductrice 23 est également constituée de sulfure de cuivre dilué dans du silicone, la proportion de silicone étant toutefois d'environ 20%. La seconde résine 23 est donc moins conductrice que la première résine 18 qui se trouve donc en quelque sorte isolée de la matière absorbante 22 par la seconde résine 23. Le corps 17 et la matière absorbante 22 sont reliés respectivement à deux électrodes 24 et 25 qui constituent les connexions du dispositif. Les électrons arrachés au silicium par l'énergie lumineuse sont en partie catapultés dans la première résine 18 où ils sont récupérés. Plus précisément et en se référant également aux figures 1 et 2, le silicium libère un électron à un niveau plus bas (fig.1). A ce stade, l'énergie lumineuse ainsi captée passe à travers la couche p entre les résines semi-conductrices 18 et 23 et les électrons sont stockés dans la résine 23 pour être à nouveau éjectés puis récupérés par la matière absorbante 22.

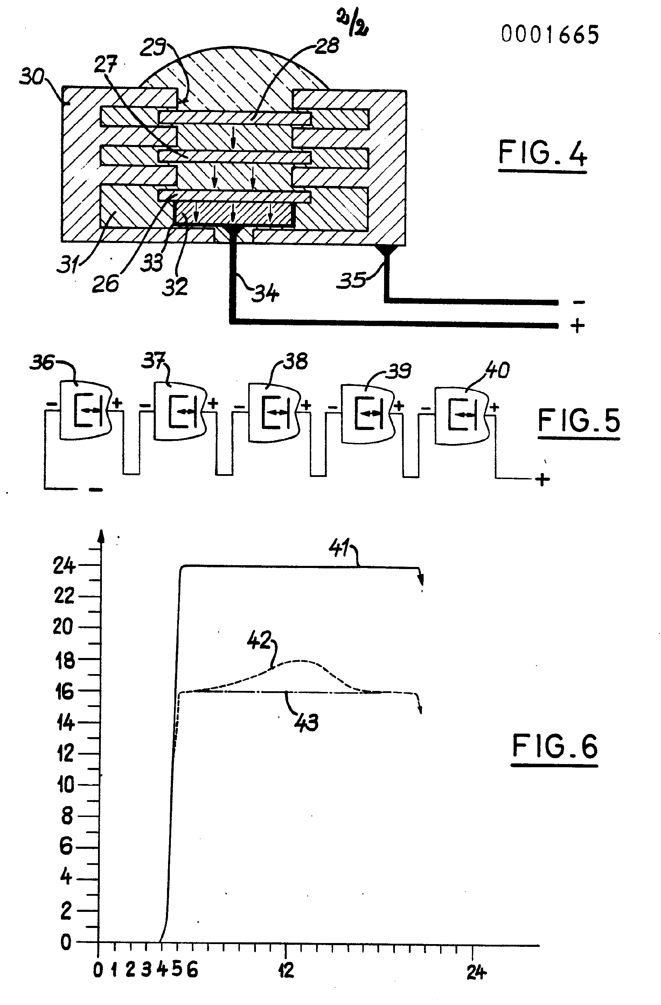

La forme d'exécution représentée à la figure 4 comporte trois cristaux de silicium 26,27 et 28 superposés, seul le cristal supérieur 28 étant directement exposé
à la lumière à travers l'ouverture 29 d'un corps métallique très conducteur 30 analogue au corps 17. Ce
corps comprend également une cavité triple remplie
d'une première résine semi-conductrice 31 identique
à la résine 18.

Seul le cristal de silicium inférieur 26 est en contact avec une matière absorbante 32 enrobée par une
seconde résine semi-conductrice 33 identique à la résine 23. Deux connexions 34 et 35 sont respectivement
reliées au corps 30 et à la matière absorbante 32. Le
processus est identique à celui qui se produit dans
le dispositif représenté à la figure 3, mais le nombre
des électrons obtenus sur les connexions est multiplié
car les électrons libérés par le premier cristal 28 à
travers la résine semi-conductrice 31 vont exciter le
cristal 27, lequel va à son tour libérer des électrons
qui vont exciter le cristal 26, ceci étant toujours
accompagné de l'effet de récupération des électrons
par la résine semi-conductrice 31. L'effet de multiplication a été confirmé par l'expérience. Le nombre
d'étages n'est bien entendu pas limité à trois.

La figure 5 représente schématiquement le montage en
série de cinq cellules photoélectriques telles que représentées à la figure 3 ou 4.

Dans le diagramme de la figure 6 on a porté en abcisse
les heures de la journée et en ordonnée la tension mesurée en volts aux bornes de plusieurs cellules branchées en série comme représenté à la figure 5. La courbe mesurée 42 varie entre 16 et 18 volts pour une tension théorique de 24 volts représentée par la courbe 41. Il est évident que la tension et le courant vont varier suivant la puissance de la lumière. Il est donc judicieux d'utiliser un circuit tampon de manière à obtenir une tension quasi constante 43.

De nombreuses variantes d'exécution sont possibles à partir de silicium et du sulfure de cuivre. Il est notamment possible d'utiliser d'autres résines synthétiques, par exemple du polyester. Suivant la résine synthétique utilisée la proportion de résine synthétique dans la résine semi-conductrice pourra varier. L'essentiel est que les résines semi-conductrices présentent une conductibilité différente, c'est-à-dire une proportion de résine synthétique différente. Cette différence sera suivant les cas de l'ordre de 5 à 20%.

Etant donné que la tension recueillie peut également varier en fonction de la température, il peut être judicieux de prévoir un radiateur afin d'avoir une température constante, de préférence d'environ 25$^{\circ}$C.

L'épaisseur du dispositif peut être inférieure à 150 microns.

Les premières expériences ont permis d'obtenir avec une surface de 20 cm$^2$ une tension de 50 volts sous une puissance de 2,5 watts.

Par rapport à une cellule photovoltaïque le dispositif

0001665

selon l'invention présente un rapport qualité/prix
et un rendement très supérieur.

Revendications de brevet

1. Dispositif générateur d'électricité à partir de la lumière, comprenant essentiellement un cristal de silicium exposé à la lumière, caractérisé par le fait que la surface non exposée à la lumière du cristal de silicium (19;28) est en contact avec une première résine semi-conductrice (18;31) constituée par un mélange de sulfure de cuivre et de résine synthétique et que ce cristal de silicium, ou un autre cristal de silicium (26), est en contact avec une deuxième résine semi-conductrice (23;33) également constituée par un mélange de sulfure de cuivre et de résine synthétique et avec une matière (22;32) absorbant les électrons, noyée dans la première résine (18;31) semi-conductrice, mais séparée de cette première résine par la deuxième résine semi-conductrice (23;33), la deuxième résine semi-conductrice contenant environ 5 à 20% de plus de résine synthétique que la première résine semi-conductrice, et par le fait qu'il comprend en outre un corps conducteur (17;30) supportant la première résine semi-conductrice et des moyens de connexions (24,25;34,35) reliés respectivement au corps conducteur et à la matière absorbante.

2. Dispositif selon la revendication 1, comprenant plusieurs cristaux de silicium distincts, caractérisé par le fait que les cristaux (26,27,28) sont superposés et séparés les uns des autres par la première résine semi-conductrice (31).

3. Dispositif selon la revendication 1 ou 2, caractéri- sé par le fait que la matière absorbante est de l'indium.

4. Dispositif selon la revendication 1,2 ou 3, caractérisé par le fait que le corps est en alliage Cr-Ni-Al.

5. Dispositif selon la revendication 1,2,3 ou 4, caractérisé par le fait que la résine synthétique est du silicone.

6. Dispositif selon la revendication 5, caractérisé par le fait que la première résine semi-conductrice contient environ 10% de silicone et que la deuxième résine semi-conductrice contient environ 20% de silicone.

7. Dispositif selon la revendication 1,2,3,4 ou 5, caractérisé par le fait que la face du cristal de silicium exposée à la lumière est protégée par un matériau isolant transparent.

0001665

FIG.1

FIG.2

FIG.3

FIG.4

FIG.5

FIG.6

0001665

| | DOCUMENTS CONSIDERES COMME PERTINENTS | | CLASSEMENT DE LA DEMANDE (Int. Cl.²) |
|---|---|---|---|
| Catégorie | Citation du document avec indication, en cas de besoin, des parties pertinentes | Revendication concernée | |
| D | FR - A - 1 389 820 (MATSUSHITA ELECTRIC INDUSTRIAL CO.)  * Page 1, page 2, colonne 2, ligne 37 - page 3, colonne 1, ligne 5; page 5, colonne 2, ligne 7 - page 6, colonne 1, ligne 8; résumé, figures 1-7 *  -- | 1,5 | H 01 L 31/04 |
| A | IBM TECHNICAL DISCLOSURE BULLETIN vol. 18, no. 8 janvier 1976, New York R.L. GAMBLIN et al: "Solar cell utilizing organic photoconductor" page 2442.  * Page 2442 *  -- | 1 | **DOMAINES TECHNIQUES RECHERCHES (Int. Cl.²)**  H 01 L 31/04 31/06 |
| A | US - A - 3 284 241 (PHILCO)  * Revendications; figures *  ---- | 1 | |

**CATEGORIE DES DOCUMENTS CITES**

X: particulièrement pertinent
A: arrière-plan technologique
O: divulgation non-écrite
P: document intercalaire
T: théorie ou principe à la base de l'invention
E: demande faisant interférence
D: document cité dans la demande
L: document cité pour d'autres raisons

&: membre de la même famille, document correspondant

Le présent rapport de recherche a été établi pour toutes les revendications

| Lieu de la recherche | Date d'achèvement de la recherche | Examinateur |
|---|---|---|
| La Haye | 21-12-1978 | ROUBERT |

CIB Form 1503.1 06.78